**Europäisches Patentamt**

**European Patent Office**

**Office européen des brevets**

(11) Veröffentlichungsnummer : **0 381 043 B1**

(12) **EUROPÄISCHE PATENTSCHRIFT**

(45) Veröffentlichungstag der Patentschrift :
**09.11.94 Patentblatt 94/45**

(51) Int. Cl.⁵ : **G03F 7/021, G03F 7/032**

(21) Anmeldenummer : **90101456.3**

(22) Anmeldetag : **25.01.90**

(54) Lichtempfindliches Gemisch und damit hergestelltes Aufzeichnungsmaterial.

(30) Priorität : **02.02.89 DE 3903001**

(43) Veröffentlichungstag der Anmeldung :
**08.08.90 Patentblatt 90/32**

(45) Bekanntmachung des Hinweises auf die
Patenterteilung :
**09.11.94 Patentblatt 94/45**

(84) Benannte Vertragsstaaten :
**DE FR GB**

(56) Entgegenhaltungen :
**EP-A- 0 071 881**
**EP-A- 0 211 391**
**US-A- 4 539 285**

(73) Patentinhaber : **HOECHST**
**AKTIENGESELLSCHAFT**
**D-65926 Frankfurt (DE)**

(72) Erfinder : **Joerg, Klaus, Dr.**
**Winkeler Strasse 2B**
**D-6507 Ingelheim (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein negativ arbeitendes lichtempfindliches Gemisch, das ein Diazoniumsalz-Kondensationsprodukt, eine polymerisierbare Verbindung, einen Photoinitiator und ein polymeres Bindemittel enthält, sowie ein damit hergestelltes Aufzeichnungsmaterial, das vorzugsweise für die Herstellung von Flachdruckplatten geeignet ist.

Kombinationen von photopolymerisierbaren Gemischen mit negativ arbeitenden Diazoverbindungen, besonders Diazoniumsalz-Polykondensationsprodukten, sind aus den DE-A 23 61 931, 29 03 270 und 30 07 212 (= GB-A 2 044 788) bekannt. Dabei wirkt entweder die Diazoverbindung selbst als Photoinitiator für die Polymerisation des Monomeren oder es wird ein zusätzlicher Photoinitiator zugesetzt. Als Vorteil wird vor allem die bessere Auflösung der Kopie gegenüber reinen photopolymerisierbaren Schichten und die erhöhte Druckauflage gegenüber Schichten angegeben, die allein Diazoverbindungen als lichtempfindliche Substanzen enthalten. Auch ist es in bestimmten Fällen möglich, die Entwicklung mit wäßrigen Lösungen oder sogar mit reinem Wasser durchzuführen.

Ein ähnliches Gemisch, das ein Bindemittel mit vernetzbaren seitenständigen Allylgruppen enthält, wird in der EP-A 104 863 beschrieben. Als Vorteil der hierin beschriebenen Gemische wird vor allem angegeben, daß die Lichtempfindlichkeit der damit hergestellten Aufzeichnungsmaterialien eine geringere Temperaturabhängigkeit aufweist. Als weiterer Vorteil wird die geringere Abhängigkeit der Lichtempfindlichkeit von dem zeitlichen Abstand zwischen Belichtung und Entwicklung angegeben. Offsetdruckplatten, die aus diesen lichtempfindlichen Gemischen hergestellt worden sind, haben jedoch den Nachteil einer verhältnismäßig geringen Auflagenstabilität und einer unerwünscht starken Tonwertzunahme während des Drucks.

In der EP-A 167 963 wird ein lichtempfindliches Gemisch aus den oben genannten Bestandteilen beschrieben, das als Diazoniumsalz-Kondensationsprodukt ein Polykondensationsprodukt aus wiederkehrenden Einheiten A-N$_2$X und B enthält, die durch Zwischenglieder, vorzugsweise Methylengruppen, miteinander verbunden sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist. Das Gemisch liefert Druckplatten mit hoher Auflage, wenn es ein wasserunlösliches Bindemittel enthält. In diesem Fall erfordert es den Zusatz organischer Lösemittel zum Entwickler.

In der EP-A 211 391 wird ein entsprechendes Gemisch beschrieben, das als Bindemittel das Umsetzungsprodukt eines Di- oder Tricarbonsäureanhydrids mit einer freie Hydroxygruppen enthaltenden polymeren organischen Verbindung enthält. Die damit erhaltenen Druckplatten lassen sich mit wäßrigen Lösungen ohne größeren Zusatz organischer Lösemittel entwickeln und ergeben ebenfalls hohe Auflagen. Die lichtempfindlichen Schichten aus diesem Gemisch sind aber bei erhöhter Temperatur klebrig und müssen daher mit einer nichtklebrigen Deckschicht, z. B. aus Polyvinylalkohol, versehen werden. Auch wird durch diese Schicht, die als Sperrschicht für Luftsauerstoff wirkt, die Durchhärtung der lichtempfindlichen Schicht verbessert. Allerdings wird die Entwickelbarkeit durch die Deckschicht verschlechtert, so daß zur Entwicklung deutlich längere Zeiten erforderlich sind. Das macht sich besonders nach längerer Lagerung oder Lagerung bei höherer Temperatur bemerkbar.

Aufgabe der Erfindung war es, ein negativ arbeitendes lichtempfindliches Gemisch vorzuschlagen, das Flachdruckplatten ergibt, deren Oberfläche auch bei erhöhter Temperatur nicht klebrig ist, deren Eigenschaften sich bei längerer und forcierter Lagerung wenig verändern und die sich zu Druckformen mit hoher Druckauflage verarbeiten lassen.

Erfindungsgemäß wird ein lichtempfindliches Gemisch vorgeschlagen, das als wesentliche Bestandteile
a) ein Diazoniumsalz-Polykondensationsprodukt,
b) eine radikalisch polymerisierbare Verbindung mit mindestens einer endständigen ethylenisch ungesättigten Gruppe und einem Siedepunkt bei Normaldruck oberhalb 100°C,
c) einen unter Einwirkung von aktinischer Strahlung Radikale bildenden Polymerisationsinitiator und
d) als Bindemittel ein in Wasser unlösliches, in organischen Lösungsmitteln und in wäßrig-alkalischen Lösungen lösliches Umsetzungsprodukt eines intramolekularen Anhydrids einer organischen Polycarbonsäure mit einem Hydroxylgruppen enthaltenden synthetischen Polymeren enthält, das keine weiteren zur Umsetzung mit Säureanhydriden befähigten funktionellen Gruppen aufweist.

Das erfindungsgemäße Gemisch ist dadurch gekennzeichnet, daß es als weiteres Bindemittel
e) ein saures organisches Polymeres mit einer Säurezahl oberhalb 70 enthält.

Erfindungsgemäß wird ferner ein lichtempfindliches Aufzeichnungsmaterial, insbesondere für die Herstellung von Flachdruckplatten, mit einem Schichtträger und einer darauf aufgebrachten lichtempfindlichen Schicht vorgeschlagen, dessen lichtempfindliche Schicht aus einem Gemisch der vorstehend angegebenen

2

Zusammensetzung besteht.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-C 20 24 244 beschrieben. Allgemein sind alle Diazoniumsalz-Polykondensationsprodukte geeignet, die in der DE-A 27 39 774 beschrieben sind.

Die Diazoniumsalzeinheiten A-N$_2$X leiten sich bevorzugt von Verbindungen der Formel $(R^1-R^2-)_pR^3-N_2X$ ab, wobei

X     das Anion der Diazoniumverbindung,

p     eine ganze Zahl von 1 bis 3,

R$^1$     einen aromatischen Rest mit mindestens einer zur Kondensation mit aktiver Carbonylverbindung befähigten Position,

R$^3$     eine Phenylengruppe,

R$^2$     eine Einfachbindung oder eine der Gruppen:

$$-(CH_2)_q-NR^4-,$$
$$-O-(CH_2)_r-NR^4-,$$
$$-S-(CH_2)_r-NR^4-,$$
$$-S-CH_2CO-NR^4-,$$
$$-O-R^5-0-,$$
$$-O-$$
$$-S-$$

oder

$$-CO-NR^4-$$

bedeuten, worin

q     eine Zahl von 0 bis 5,

r     eine Zahl von 2 bis 5,

R$^4$     Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

R$^5$     eine Arylengruppe mit 6 bis 12 C-Atomen ist.

Von den genannten Verbindungsklassen werden die Kondensationsprodukte der Diphenylamin-4-diazoniumsalze, die gegebenenfalls durch Alkyl-, Alkoxygruppen oder Halogenatome substituiert sind, bevorzugt. Als Zweitkomponenten B werden die gegebenenfalls substituierten Diphenylether, Diphenylsulfide, Diphenylmethane oder Diphenyle bevorzugt. Dabei werden für die Kondensation die Bis-methoxymethyl-, Bis-hydroxymethyl- oder Bis-acetoxymethylderivate der Grundkörper mit besonderem Vorteil eingesetzt. Das Kondensationsprodukt kann im Mittel 0,1 bis 50, bevorzugt 0,2 bis 20 Einheiten B je Einheit A-N$_2$X enthalten.

Der Mengenanteil des Diazoniumsalz-Polykondensationsprodukts in dem Gemisch liegt im allgemeinen zwischen 5 und 60, vorzugsweise zwischen 10 und 40 Gew.-%, bezogen auf den Gesamtgehalt an nichtflüchtigen Bestandteilen.

Weitere besonders vorteilhafte Polykondensationsprodukte werden erhalten, indem ein ggf. substituiertes Diphenylamindiazoniumsalz zuerst mit einer aromatischen Verbindung R'-O-CH$_2$-BH und danach mit einer aromatischen Verbindung R'-O-CH$_2$-B-CH$_2$-O-R' kondensiert wird, wobei R' ein Wasserstoffatom, ein Alkyl- oder aliphatischer Acylrest ist. Diese Kondensationsprodukte sind in der EP-A 126 875 beschrieben.

Als radikalisch polymerisierbare Verbindungen werden bevorzugt Acryl- oder Methacrylsäureester von mehrwertigen, insbesondere primären Alkoholen eingesetzt. Die Alkohole können 1 bis 6, bevorzugt 2 bis 4 OH-Gruppen enthalten. Beispiele für geeignete Ester sind Trimethylolpropantriacrylat, Pentaerythrittri- und -tetraacrylat, Dipentaerythrithexamethacrylat, Propylenglykoldimethacrylat, Glycerindimethacrylat, Triethylenglykoldimethacrylat, Polyethylenglykoldiacrylat und Bisacrylate von oxyethylierten Bisphenol-A-Derivaten. Es sind auch die niedermolekularen, Urethangruppen enthaltenden Acrylate und Methacrylate geeignet, die durch Umsetzen von Hydroxyalkylacrylat oder -methacrylat mit zwei- oder mehrwertigen Isocyanaten erhalten werden. Die Isocyanate können wiederum durch Umsetzen von Diisocyanaten mit Diolen oder Triolen zu oligomeren Verbindungen erhalten worden sein. Die Menge an polymerisierbaren Verbindungen liegt im allgemeinen zwischen 10 und 65, bevorzugt bei 30 bis 60 Gew.-%.

Als Photoinitiatoren können eine Vielzahl von Verbindungen, gegebenenfalls auch Gemische von zwei oder mehreren verschiedenen, oftmals synergistisch wirkenden Verbindungen Verwendung finden. Beispiele sind Benzoin und seine Derivate, Mehrkernchinone, Acridinderivate, Phenazinderivate, aromatisch substituierte Oxdiazole, z. B. 2,5-Bis-(4-diethylamino-phenyl)-1,3,4-oxdiazol, Benzildimethylketal, aromatisch substituierte Bis-trichlormethyl-s-triazine oder trichlormethylsubstituierte Carbonylmethylenheterocyclen, z. B. 2-(p-Trichlormethyl-benzoylmethylen)-3-ethyl-benzthiazolin. Die Trichlormethylverbindungen werden besonders bevorzugt. Die Menge des Photoinitiators liegt im allgemeinen zwischen 0,05 und 10, bevorzugt zwischen 0,5 und 5 Gew.-%.

Die in dem erfindungsgemäßen Gemisch enthaltenen polymeren Umsetzungsprodukte (d) sind in den EP-A 211 391 und EP-A 152 819 beschrieben. Das zur Herstellung dieser Produkte eingesetzte Säureanhydrid leitet sich bevorzugt von einer Di- oder Tricarbonsäure, insbesondere einer Dicarbonsäure, ab.

Beispiele für geeignete Säureanhydride sind:

Maleinsäureanhydrid und Derivate,

z.B. Dimethylmaleinsäureanhydrid oder Citraconsäureanhydrid,

Bernsteinsäureanhydrid und Derivate,

z.B. Methylbernsteinsäureanhydrid,

Glutarsäureanhydrid und Derivate, z.B. 3-Methylglutarsäureanhydrid, 3,3-Tetramethylen-glutarsäureanhydrid oder Camphersäureanhydrid,

3-Oxa-glutarsäureanhydrid und Derivate,

Phthalsäureanhydrid und Substitutionsprodukte,

z.B. Chlor-, Nitro- oder Carboxyphthalsäureanhydrid, teilweise oder vollständig hydrierte Phthalsäureanhydride, z.B. Hexahydrophthalsäureanhydrid oder Cyclohexen-1,2-dicarbonsäureanhydrid,

Naphthalin-2,3-dicarbonsäureanhydrid oder Naphthalin-1,8-dicarbonsäureanhydrid und deren Substitutionsprodukte,

Pyridin-o-dicarbonsäureanhydrid und dessen Substitutionsprodukte,

Pyrazin-o-dicarbonsäureanhydrid und dessen Substitutionsprodukte,

Furan-o-dicarbonsäureanhydrid oder Furan-2,5-dicarbonsäureanhydrid, deren Substitutionsprodukte sowie deren teilweise oder vollständig hydrierte Derivate,

Thiophen-o-dicarbonsäureanhydrid oder Thiophen-2,5-dicarbonsäureanhydrid, deren Substitutionsprodukte sowie deren ganz oder teilweise hydrierte Derivate,

di- oder polycyclische Anhydride, die durch Diels-Alder-Reaktion eines Diens mit Maleinsäureanhydrid entstehen, z.B. die Additionsprodukte aus Furan, Anthracen, Cyclohexadien-1,3 oder Cyclopentadien und Maleinsäureanhydrid.

Bevorzugt werden die Reaktionsprodukte mit Malein-, Phthal-, Bernstein- und 3-Oxa-glutarsäureanhydrid.

Als Hydroxygruppen enthaltende synthetische Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht.

Als Polymere mit Vinylalkoholeinheiten sind teilverseifte Polyvinylester, Polyvinylacetale mit freien Hydroxygruppen sowie entsprechende Umsetzungsprodukte von Copolymeren bzw. Copolymerisaten mit Vinylester- oder Vinylacetal- oder Vinylalkoholeinheiten geeignet.

Das Molekulargewicht der polymeren Umsetzungsprodukte kann innerhalb weiter Bereiche variieren. Im allgemeinen werden Produkte mit mittleren Molekulargewichten zwischen 5.000 und etwa 200.000 und darüber, vorzugsweise zwischen 10.000 und 100.000 eingesetzt. Die Säurezahl der Umsetzungsprodukte kann im allgemeinen zwischen 5 und 80, bevorzugt zwischen 10 und 70 liegen.

Das weitere Bindemittel (e) ist ein saures Polymeres, das sich in schwach alkalischen wäßrigen Lösungen leichter löst als das polymere Umsetzungsprodukt (d). Es kann z. B. eine der Gruppen -COOH, -$PO_3H_2$, -$SO_3H$, -$SO_2$-NH-, $SO_2NHSO_2$- und -$SO_2NHCO$- enthalten, wobei Carboxylgruppen bevorzugt werden. Seine Säurezahl beträgt mindestens 70, vorzugsweise 100 bis 300. Beispiele für geeignete Polymere sind Maleinatharze, Polymerisate und Copolymerisate von N-(p-Tolylsulfonyl)-carbaminsäure-β-(methacryloyloxy)-ethylester, Vinylacetat/Crotonsäure- und Styrol/Maleinsäureanhydrid- bzw. Styrol/Maleinsäurepartialester-Copolymere. Mit besonderem Vorteil werden Copolymere der Acryl- und Methacrylsäure eingesetzt. Als Comonomere sind vorzugsweise Alkyl(meth)acrylate, Styrol, Acrylnitril u. ä. geeignet. Die Copolymeren können aus zwei oder mehreren Monomeren aufgebaut sein. Derartige Copolymere sind in der DE-C 70 64 080, der DE-A 23 63 806 und der EP-A 173 057 beschrieben.

Der Mengenanteil an Polymeren (e) beträgt im allgemeinen 1 bis 25, vorzugsweise 4 bis 15 Gew.-%, bezogen auf die nichtflüchtigen Anteile des lichtempfindlichen Gemischs. Das Gewichtsverhältnis von (d) zu (e) liegt bevorzugt zwischen 95:5 und 50:50. Der Anteil des Gemischs an Bindemitteln insgesamt beträgt im allgemeinen 5 bis 80, vorzugsweise 10 bis 50 Gew.-%, bezogen auf dessen nichtflüchtige Anteile.

Die erfindungsgemäßen Gemische können ferner Säuren, Inhibitoren für die thermische Polymerisation, Farbstoffe, Pigmente, Verlaufmittel, Weichmacher, Netzmittel und andere übliche Zusätze enthalten.

Die Gemische werden bevorzugt zur Herstellung lichtempfindlicher Druckplatten, insbesondere Flachdruckplatten, eingesetzt. In diesem Fall werden als Schichtträger vorwiegend Metalle, wie Zink, Stahl, verchromter Stahl, Messing/Chrom, Kupfer/Chrom oder Aluminium verwendet. Für Flachdruckplatten wird Aluminium bevorzugt, insbesondere mechanisch, chemisch oder elektrolytisch aufgerauhtes Aluminium, das bevorzugt noch mit einer anodisch erzeugten Oxidschicht versehen ist.

Die Gemische können auch in der Photoresisttechnik eingesetzt werden, z. B. zur Herstellung von Hoch-, Tief- oder Mehrmetalldruckplatten oder von gedruckten Schaltungen. Bei dieser Anwendung ist in vielen Fällen die erhöhte Auflösung gegenüber den sonst verwendeten photopolymerisierbaren Gemischen von besonderem Vorteil.

Bei allen Anwendungen kommen als Vorteile der erfindungsgemäßen Gemische gegenüber den bekannten Gemischen auf Basis Photopolymer/Diazoniumsalz-Kondensat eine erhöhte Lichtempfindlichkeit, erhöhte Lagerfähigkeit und verbesserte Haftung der lichtempfindlichen Schicht, insbesondere im belichteten Zustand, zur Geltung.

Besonders überraschend ist die Verbesserung der Entwickelbarkeit nach längerer Lagerung oder Lagerung bei erhöhter Temperatur. Es wurde gefunden, daß dieser Vorteil nicht einfach durch Erhöhung der Säurezahl des Polymeren (d) erreicht werden kann. Es ist vielmehr die vorstehend angegebene ganz bestimmte Kombination von Bindemitteln erforderlich.

Als Lösemittel zur Bereitung der Beschichtungslösungen können je nach den Schichtbestandteilen z. B. Alkohole, wie Methanol und Ethanol; Glykolether wie Ethylenglykolmonoethylether, Propylenglykolmonomethylether; Dimethylformamid und Diethylformamid, Ether wie Dioxan, Tetrahydrofuran; Ester wie Essigsäureethylester, Butylacetat, Ethylenglykolmethyletheracetat; Ketone wie Methylethylketon, Cyclohexanon usw., verwendet werden.

Die lichtempfindliche Schicht kann in üblicher Weise durch Aufbringen der Lösung ihrer Bestandteile auf den Schichtträger erzeugt werden. Sie kann auch zunächst auf einen temporären Schichtträger aufgebracht werden, von dem sie mechanisch abtrennbar ist, und durch Laminieren auf den endgültigen Schichtträger, z. B. eine Nickelfolie oder die Kupferschicht eines Leiterplatten-Basismaterials übertragen werden.

Bei der Verarbeitung wird das Aufzeichnungsmaterial bildmäßig durch eine Vorlage belichtet. Zur Bildbelichtung kann jede in der Reproduktionstechnik gebräuchliche Lichtquelle dienen, die im langwelligen UV-Bereich emittiert, z. B. Kohlenbogenlampen, Quecksilberhochdrucklampen, Xenonimpulslampen und andere. Auch Elektronen- oder Laserstrahlung ist zur Bildaufzeichnung geeignet. Nach der Belichtung kann die Schicht an den Bildstellen durch Erwärmen auf Temperaturen oberhalb 60 °C zusätzlich gehärtet werden.

Die lichtempfindliche Schicht kann mit einer für Sauerstoff wenig durchlässigen Deckschicht überzogen werden, die vorzugsweise wasserlöslich ist. Als transparente wasserlösliche Polymere zur Herstellung dieser Schicht werden z. B. Polyvinylalkohol oder Polyvinylpyrrolidon eingesetzt, denen ggf. Tenside oder Säuren zugesetzt werden können. Durch den Zusatz von Säuren, besonders Mineralsäuren, z. B. Phosphor- oder Schwefelsäure, wird die Lagerfähigkeit des Materials zusätzlich erhöht. Die Säuremenge kann etwa 5 bis 50 Gew.-%, bezogen auf das Gewicht der Deckschicht, betragen. Die Deckschicht hat nach dem Trocknen vorzugsweise ein Schichtgewicht von 0,2 bis 3 g/m².

Nach der Belichtung wird mit einem geeigneten Entwickler entwickelt. Als Entwickler können z. B. wäßrige Netzmittellösungen, ggf. unter Zusatz von Alkali, deren Gemische mit organischen Lösemitteln, wäßrige Salzlösungen, wäßrige Lösungen von Säuren, z. B. von Phosphorsäuren, denen wiederum Salze oder organische Lösemittel zugesetzt werden können, oder wäßrig-alkalische Entwickler verwendet werden, z. B. wäßrige Lösungen von Natriumsalzen der Phosphorsäure oder der Kieselsäure. Auch diesen Entwicklern können organische Lösemittel zugesetzt werden. Es ist in manchen Fällen auch möglich, mit Wasser verdünnte organische Lösemittel zu verwenden. Die Entwickler können noch weitere Bestandteile, z. B. Netzmittel und Hydrophilierungsmittel, enthalten.

Die Entwicklung erfolgt in bekannter Weise, z. B. durch Tauchen und/oder Überwischen oder Besprühen mit der Entwicklerflüssigkeit. Dabei werden die nicht belichteten Schichtbereiche gelöst.

Die entwickelte Druckplatte kann noch zusätzlich durch Erwärmen auf eine Temperatur im Bereich von 150 - 230 °C nachgehärtet werden. Im allgemeinen reicht eine Zeit von 2 bis 20 Minuten für die Nachhärtung aus. Eine weitere Möglichkeit ist die Nachhärtung durch Belichten bzw. Bestrahlen der entwickelten Druckform. Diese Art der Nachbehandlung ist bei einer Druckplatte aus dem erfindungsgemäßen Gemisch wesentlich wirkungsvoller als bei einer Platte, deren lichtempfindliche Schicht nur aus einem photopolymerisierbaren Gemisch besteht. Da die erfindungsgemäße Druckplatte gegenüber Luftsauerstoff wesentlich unempfindlicher ist als eine reine Photopolymerplatte, läßt sie sich auch ohne sauerstoffhemmende Deckschicht, also in Gegenwart von Luftsauerstoff, durch Belichten aushärten.

Die nachstehenden Beispiele beschreiben die Herstellung der erfindungsgemäßen lichtempfindlichen Gemische und der mit diesen hergestellten Aufzeichnungsmaterialien. In den Beispielen stehen Gewichtsteile (Gt.) und Volumenteile (Vt.) zueinander im Verhältnis von g zu ml. Prozentangaben sind, wenn nichts anderes angegeben ist, Gewichtsprozente, Temperaturen sind in °C angegeben.

Beispiel 1

a) Ein Aluminiumblech wurde elektrochemisch aufgerauht und anodisiert, anschließend zur Verbesserung der Hydrophilie mit einer wäßrigen Lösung von Polyvinylphosphonsäure behandelt. Darauf wurde die folgende Mischung in einer solchen Menge aufgetragen, daß ein Trockengewicht von 1,8 g/qm erreicht wurde:

| | |
|---|---|
| 0,450 Gt | eines Copolymeren aus 82 % Methylmethacrylat und 18 % Methacrylsäure (Säurezahl 117), |
| 1,050 Gt | des Umsetzungsprodukts eines Polyvinylbutyrals mit einem Molekulargewicht von 70.000 - 80.000, das 71 % Gew.-% Vinylbutyral-, 2 Gew.-% Vinylacetat- und 27 Gew.-% Vinylalkoholeinheiten enthielt, mit Maleinsäureanhydrid (Säurezahl des Produkts 30), |
| 0,450 Gt | eines Diazoniumsalz-Polykondensationsprodukts aus 1 mol 3-Methoxy-diphenylamin-4-diazoniumsulfat und 1 mol 4,4'-Bis-methoxymethyl-diphenylether, ausgefällt als Mesitylensulfonat, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon. |

Diese Schicht wurde mit einer 2%igen wäßrigen Lösung von Polyvinylalkohol (12 % Restacetatgruppen, K-Wert 4), die zusätzlich 0,6 % Phosphorsäure enthielt, überzogen. Die so erhaltenen Druckplatten wurden zur Untersuchung der Entwickelbarkeit nach Lagerung bei erhöhter Temperatur in einem Umlufttrockenschrank eine bis vier Stunden bei 100 °C gelagert, anschließend unter einer Testvorlage belichtet und mit dem folgenden Entwickler, bestehend aus

| | |
|---|---|
| 3,00 Gt | Natriumdodecylsulfat, |
| 5,40 Gt | Kaliumpelargonat, |
| 4,00 Gt | Phenoxyethanol, |
| 2,00 Gt | Kaliumtetraborat x 4H$_2$O, |
| 85,50 Gt | Wasser |

übergossen und durch Reiben mit einem Tampon (graphic pad, entwickelt. Belichtungszeiten und Entwicklungszeiten für eine 20 x 10 cm große Probe nach forcierter Lagerung sind in Tabelle 1 zusammengestellt.

Statt des Gemischs von Pentaerythrittetraacrylat und -triacrylat wurden jeweils gleiche Mengen Trimethylolpropantriethoxytriacrylat, Hexandioldiacrylat, Tripropylenglykoldiacrylat, N,N'-Methylen-bisacrylamid oder des Umsetzungsprodukts aus zwei mol Hydroxyethylmethacrylat und einem mol Trimethylhexamethylendiisocyanat eingesetzt. Die Entwicklungszeiten der Plattenproben nach Lagerung bei 100 °C lagen alle im gleichen Bereich wie bei dem oben angegebenen Monomerengemisch.

b) In einem weiteren Versuch wurde die oben angegebene Beschichtungslösung in solcher Menge aufgebracht, daß nach dem Trocknen ein Schichtgewicht von 2,7 g/qm erhalten wurde. Die Platte wurde wie oben beschrieben gelagert, belichtet und entwickelt. Die Entwicklungszeiten sind in Tabelle 1 zusammengestellt.

Vergleichsbeispiel 1

Druckplatte entsprechend der DE-A 35 28 309:
Eine Lösung von

| | |
|---|---|
| 1,500 Gt | des in Beispiel 1 angegebenen Umsetzungsprodukts eines Polyvinylbutyrals, |
| 0,450 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Vergleichsbeispiel 2

Zum Vergleich wurde eine Druckplatte entsprechend der DE-A 35 28 309 hergestellt; es wurde jedoch ein Bindemittel mit erhöhter Säurezahl benutzt.

Eine Lösung von

| | |
|---|---|
| 1,500 Gt | des Umsetzungsprodukts eines Polyvinylbutyrals, wie in Beispiel 1, jedoch mit der Säurezahl 64, |
| 0,450 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 2

Eine Lösung von

| | |
|---|---|
| 0,600 Gt | des in Beispiel 1 angegebenen Copolymeren, |
| 0,900 Gt | des in Beispiel 1 angegebenen Umsetzungsprodukts, |
| 0,450 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 3

Eine Lösung von

| | |
|---|---|
| 0,450 Gt | des in Beispiel 1 angegebenen Copolymeren, |
| 1,050 Gt | des in Beispiel 1 angegebenen Umsetzungsprodukts, |
| 0,540 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 4

  Eine Lösung von

| | |
|---|---|
| 0,450 Gt | des in Beispiel 1 angegebenen Copolymeren, |
| 1,050 Gt | des in Beispiel 1 angegebenen Umsetzungsprodukts, |
| 0,450 Gt | des in Beispiel 1 angegebenen Diazoniumsalz-Polykondensationsprodukts, |
| 0,090 Gt | Viktoriareinblau FGA (C.I. Basic Blue 81), |
| 1 ,500 Gt | Trimethylolethantriacrylat, |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 5

  Eine Lösung von

| | |
|---|---|
| 0,450 Gt | des in Beispiel 1 angegebenen Copolymeren, |
| 1,050 Gt | des Umsetzungsprodukts des in Beispiel 1 angegebenen Polyvinylbutyrals mit Bernsteinsäureanhydrid (Säurezahl des Produkts 64), |
| 0,500 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 6

  Eine Lösung von

| | |
|---|---|
| 0,450 Gt | des in Beispiel 1 angegebenen Copolymeren, |
| 1,050 Gt | des in Beispiel 1 angegebenen Umsetzungsprodukts, |
| 0,540 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Vergleichsbeispiel 3

Eine Lösung von

| | |
|---|---|
| 1,500 Gt | des in Beispiel 5 angegebenen Umsetzungsprodukts, |
| 0,500 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 7

Eine Lösung von

| | |
|---|---|
| 0,450 Gt | eines Copolymeren aus Styrol und Maleinsäureanhydrid (1 : 1), wobei die Anhydridgruppen teilweise mit n-Butanol umgesetzt sind (SZ 185), |
| 1,050 Gt | des in Beispiel 1 angegebenen Umsetzungsprodukts, |
| 0,450 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 8

Eine Lösung von

| | |
|---|---|
| 0,450 Gt | des in Beispiel 1 angegebenen Copolymeren, |
| 1,050 Gt | des in Beispiel 1 angegebenen Umsetzungsprodukts, |
| 0,450 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2,5-Bis-(4-diethylamino-phenyl)-1,3,4-oxdiazol, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 9

     Eine Lösung von

| | |
|---|---|
| 0,450 Gt | des in Beispiel 1 angegebenen Copolymeren, |
| 1,050 Gt | des in Beispiel 1 angegebenen Umsetzungsprodukts, |
| 0,450 Gt | des in Beispiel 1 angegebenen Diazoniumsalz-Polykondensationsprodukts, aber ausgefällt als Methansulfonat, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 10

     Eine Lösung von

| | |
|---|---|
| 0,450 Gt | des in Beispiel 1 angegebenen Copolymeren, |
| 1,050 Gt | des in Beispiel 1 angegebenen Umsetzungsprodukts, |
| 0,450 Gt | des in Beispiel 1 angegebenen Diazoniumsalz-Polykondensationsprodukts, aber ausgefällt als 1-Hydroxy-3-methoxy-benzophenon-4-sulfonat, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 48,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Beispiel 11

     Eine Lösung von

| | |
|---|---|
| 0,150 Gt | des in Beispiel 1 angegebenen Copolymeren, |
| 1,350 Gt | des in Beispiel 1 angegebenen Umsetzungsprodukts, |
| 0,450 Gt | des in Beispiel 1 angegebenen Diazoniumsalz-Polykondensationsprodukts, |
| 0,090 Gt | Viktoriareinblau FGA (C.I. Basic Blue 81), |
| 1,500 Gt | Pentaerythrittetraacrylat/-triacrylat (technisches Gemisch), |
| 0,120 Gt | 2-(4-Styryl-phenyl)-4,6-bis-trichlormethyl-s-triazin, |
| 0,040 Gt | Phosphorsäure (85 %) und |
| 0,007 Gt | Phenylazodiphenylamin in |
| 47,700 Gt | 2-Methoxy-ethanol und |
| 40,600 Gt | Butanon |

wurde auf ein Aluminiumblech, das entsprechend Beispiel 1 vorbehandelt wurde, zu einem Trockenschichtgewicht von 1,8 g/qm aufgebracht und mit der oben beschriebenen Sauerstoffsperrschicht überzogen. Proben dieser Druckplatte wurden einer forcierten Lagerung bei 100 °C entsprechend Beispiel 1 unterzogen. Anschließend wurden die Platten belichtet und mit der in Beispiel 1 angegebenen Entwicklerlösung entwickelt. Die Entwicklungszeiten (Handentwicklung) für die 20 x 10 cm großen Proben sind in Tabelle 1 aufgelistet.

Tabelle 1

Entwicklungszeiten für 20 x 10 cm große Proben nach forcierter Lagerung bei 100 °C (alle Proben wurden 20 Sekunden belichtet, alle Zeitangaben in Sekunden, V = Vergleichsbeispiel)

| Beispiel | 0-Wert | 1h | 2h | 3h | 4h |
|---|---|---|---|---|---|
| 1 a | 5 | 10 | 14 | 20 | 23 |
| 1 b | 8 | 12 | 17 | 22 | 28 |
| 2 | 5 | 10 | 16 | 18 | 22 |
| 3 | 6 | 10 | 12 | 20 | 27 |
| 4 | 6 | 9 | 15 | 15 | 25 |
| 5 | 5 | 6 | 7 | 10 | 20 |
| 6 | 5 | 7 | 9 | 13 | 20 |
| 7 | 6 | 9 | 10 | 17 | 28 |
| 8 | 6 | 9 | 14 | 17 | 21 |
| 9 | 7 | 12 | 14 | 20 | 25 |
| 10 | 6 | 8 | 8 | 12 | 12 |
| 11 | 6 | 11 | 12 | 22 | 25 |
| V1 | 7 | 13 | 17 | >45 | >45 |
| V2 | 7 | 10 | 16 | >45 | >45 |
| V3 | 7 | 7 | 15 | 30 | >45 |

**Patentansprüche**

1. Lichtempfindliches Gemisch, das als wesentliche Bestandteile
   a) ein Diazoniumsalz-Polykondensationsprodukt,
   b) eine radikalisch polymerisierbare Verbindung mit mindestens einer endständigen ethylenisch ungesättigten Gruppe und einem Siedepunkt bei Normaldruck oberhalb 100°C,
   c) einen unter Einwirkung von aktinischer Strahlung Radikale bildenden Polymerisationsinitiator und
   d) als Bindemittel ein in Wasser unlösliches, in organischen Lösemitteln und in wäßrig-alkalischen Lösungen lösliches Umsetzungsprodukt eines intramolekularen Anhydrids einer organischen Polycarbonsäure mit einem Hydroxylgruppen enthaltenden synthetischen Polymeren enthält, das keine anderen zur Umsetzung mit Säureanhydriden befähigten funktionellen Gruppen aufweist,
   dadurch gekennzeichnet, daß es als weiteres Bindemittel
   e) ein saures organisches Polymeres mit einer Säurezahl oberhalb 70 enthält.

2. Lichtempfindliches Gemisch nach Anspruch 1, dadurch gekennzeichnet, daß das weitere Bindemittel Carboxylgruppen als Säuregruppen enthält.

**3.** Lichtempfindliches Gemisch nach Anspruch 1, dadurch gekennzeichnet, daß das weitere Bindemittel (e) ein Acryl- oder Methacrylsäurecopolymeres ist.

**4.** Lichtempfindliches Gemisch nach Anspruch 1, dadurch gekennzeichnet, daß es das weitere Bindemittel (e) in einer Menge von 5 bis 50 Gew.-%, bezogen auf die Gesamtmenge an Bindemitteln enthält.

**5.** Lichtempfindliches Gemisch nach Anspruch 1, dadurch gekennzeichnet, daß die organische Polycarbonsäure eine Di- oder Tricarbonsäure ist.

**6.** Lichtempfindliches Gemisch nach Anspruch 1, dadurch gekennzeichnet, daß das Hydroxylgruppen enthaltende Polymere ein Polymeres mit Vinylalkoholeinheiten ist.

**7.** Lichtempfindliches Gemisch nach Anspruch 1, dadurch gekennzeichnet, daß das Diazoniumsalz-Polykondensationsprodukt aus wiederkehrenden Einheiten A-N$_2$X und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

**8.** Lichtempfindliches Gemisch nach Anspruch 1, dadurch gekennzeichnet, daß die radikalisch polymerisierbare Verbindung ein Acryl- oder Methacrylsäureester eines mehrwertigen Alkohols ist.

**9.** Lichtempfindliches Gemisch nach Anspruch 1, dadurch gekennzeichnet, daß der Polymerisationsinitiator eine Verbindung mit mindestens einer photolytisch spaltbaren Trichlormethylgruppe ist.

**10.** Lichtempfindliches Gemisch nach Anspruch 1, dadurch gekennzeichnet, daß es 5 bis 60 Gew.-% Diazoniumsalz-Polykondensationsprodukt (a), 10 bis 65 Gew.-% radikalisch polymerisierbare Verbindung (b), 0,05 bis 10 Gew.-% Initiator (c) und 5 bis 80 Gew.-% Bindemittel (d) und (e) enthält.

**11.** Lichtempfindliches Aufzeichnungsmaterial mit einem Schichtträger und einer darauf aufgebrachten lichtempfindlichen Schicht, dadurch gekennzeichnet, daß die lichtempfindliche Schicht aus einem Gemisch gemäß Anspruch 1 besteht.

## Claims

**1.** A light-sensitive mixture which contains as essential constituents
a) a diazonium salt polycondensation product,
b) a free-radical polymerizable compound having at least one terminal ethylenically unsaturated group and a boiling point at atmospheric pressure above 100° C,
c) a polymerization initiator which forms free radicals under the action of actinic radiation
and
d) as a binder, a water-insoluble reaction product which is soluble in organic solvents and in aqueous-alkaline solutions, which is a reaction product of an intramolecular anhydride of an organic polycarboxylic acid with a hydroxyl-containing synthetic polymer which has no other functional groups capable of reacting with acid anhydrides,
characterized in that it contains, as a further binder,
e) an acid organic polymer having an acid number above 70.

**2.** The light-sensitive mixture as claimed in claim 1, wherein the further binder contains carboxyl groups as acid groups.

**3.** The light-sensitive mixture as claimed in claim 1, wherein the further binder (e) is an acrylic or methacrylic acid copolymer.

**4.** The light-sensitive mixture as claimed in claim 1, containing the further binder (e) in an amount of from 5 to 50 % by weight, based on the total amount of binder.

5. The light-sensitive mixture as claimed in claim 1, wherein the organic polycarboxylic acid is a dicarboxylic or tricarboxylic acid.

6. The light-sensitive mixture as claimed in claim 1, wherein the hydroxyl-containing polymer is a polymer having vinyl alcohol units.

7. The light-sensitive mixture as claimed in claim 1, wherein the diazonium salt polycondensation product comprises repeat units $A-N_2X$ and B which are bonded to one another through intermediate members, preferably methylene groups, which are derived from condensable carbonyl compounds, A being the radical of an aromatic diazonium compound which is condensable with formaldehyde and B being the radical of a compound which is free of diazonium groups and condensable with formaldehyde, in particular of an aromatic amine, of a phenol, of a phenol ether, of an aromatic thioether, of an aromatic hydrocarbon, of an aromatic heterocyclic compound or of an organic acid amide.

8. The light-sensitive mixture as claimed in claim 1, wherein the free radical, polymerizable compound is an acrylic or methacrylic acid ester of a polyhydric alcohol.

9. The light-sensitive mixture as claimed in claim 1, wherein the polymerization initiator is a compound having at least one photolytically cleavable trichloromethyl group.

10. The light-sensitive mixture as claimed in claim 1, which contains 5 to 60 % by weight of diazonium salt polycondensation product (a), 10 to 65 % by weight of free-radical polymerizable compound (b), 0.05 to 10 % by weight of initiator (c) and 5 to 80 % by weight of binder (d) and (e).

11. A light-sensitive recording material comprising support material and, applied thereto, a light-sensitive layer, wherein the light-sensitive layer is composed of a mixture as claimed in claim 1.


## Revendications

1. Composition photosensible qui contient, comme constituants essentiels:
   a) un polycondensat de sel de diazonium,
   b) un composé polymérisable par voie radicalaire comportant au moins un groupe à insaturation éthylénique terminale et un point de fusion à pression normale supérieure à 100°C,
   c) un initiateur de polymérisation générateur de radicaux libres sous l'effet du rayonnement actinique, et
   d) comme liant, un produit, insoluble dans l'eau et soluble dans des solvants organiques et des solutions alcalines aqueuses, provenant de la réaction d'un anhydride intramoléculaire d'un acide polycarboxylique organique avec un polymère synthétique à groupes hydroxyle, qui ne possède pas d'autres groupes fonctionnels capables de réagir avec des anhydrides d'acide,
   caractérisée en ce qu'elle contient, comme liant supplémentaire:
   e) un polymère organique acide d'indice d'acide supérieur à 70.

2. Composition photosensible selon la revendication 1, caractérisée en ce que le liant supplémentaire contient des groupes carboxyle comme groupes acides.

3. Composition photosensible selon la revendication 1, caractérisée en ce que le liant supplémentaire (e) est un copolymère d'acide acrylique ou méthacrylique.

4. Composition photosensible selon la revendication 1, caractérisée en ce qu'elle renferme le liant supplémentaire (e) à raison de 5 à 50 % en poids, par rapport à la quantité totale de liants.

5. Composition photosensible selon la revendication 1, caractérisée en ce que l'acide organique polycarboxylique est un acide di- ou tricarboxylique.

6. Composition photosensible selon la revendication 1, caractérisée en ce que le polymère à groupes hydroxyle est un polymère comportant des motifs alcool vinylique.

7. Composition photosensible selon la revendication 1, caractérisée en ce que le polycondensat de sel de diazonium est constitué de motifs $A-N_2X$ et récurrents, qui sont liés entre eux par des ponts, de préférence des groupes méthylène, dérivés de composés carbonylés condensables, A étant le résidu d'un composé diazonium aromatique condensable avec du formaldéhyde et B étant le résidu d'un composé condensable avec du formaldéhyde et exempt de groupes diazonium, en particulier d'une amine aromatique, d'un phénol, d'un éther phénolique, d'un thioéther aromatique, d'un hydrocarbure aromatique, d'un composé hétérocyclique aromatique ou d'un amide d'acide organique.

8. Composition photosensible selon la revendication 1, caractérisée en ce que le composé polymérisable par voie radicalaire est un ester d'un acide acrylique ou méthacrylique et d'un polyol.

9. Composition photosensible selon la revendication 1, caractérisée en ce que l'initiateur de polymérisation est un composé comportant au moins un groupe trichlorométhyle clivable par photolyse.

10. Composition photosensible selon la revendication 1, caractérisée en ce qu'elle contient 5 à 60 % en poids de polycondensat de sel de diazonium (a), 10 à 65 % en poids de composé polymérisable par voie radicalaire (b), 0,05 à 10 % en poids d'initiateur (c) et 5 à 80 % en poids de liants (d) et (e).

11. Matériau d'enregistrement photosensible comportant un support de couche et une couche photosensible déposée dessus, caractérisé en ce que la couche photosensible se compose d'un mélange selon la revendication 1.